# EUROPEAN PATENT APPLICATION

(11) **EP 4 297 252 A1**
(43) Date of publication of application: **27.12.2023**
(21) Application number: 23180103.6
(22) Date of filing: 19.06.2023
(51) Int. Cl.: H02K 5/22, H02K 7/116, H02K 11/33

(54) **ELECTRIC DRIVE ASSEMBLY SYSTEM, VEHICLE AND ASSEMBLY METHOD OF ELECTRIC DRIVE ASSEMBLY SYSTEM**

(30) Priority: 20.06.2022 CN 202210699993
(71) Applicant: Valeo eAutomotive Germany GmbH, 91056 Erlangen (DE)
(72) Inventor: DENG, Xiaoxue, 91056 Erlangen (DE); JIN, Yejin JIN, 91056 Erlangen (DE); LIAO, Binhong, 91056 Erlangen (DE); CHENG, Xing-Ang, 91056 Erlangen (DE); ZHANG, Joshua-Shu, 91056 Erlangen (DE); SUN, Ray-Lei, 91056 Erlangen (DE)
(74) Representative: Valeo Powertrain Systems

(57) **Abstract**

The present disclosure relates to an electric drive assembly system, a vehicle and an assembly method of an electric drive assembly system. The electric drive assembly system comprises: a housing, comprising a body and a cover; and an the following, disposed in the housing: an electric machine comprising a rotor shaft; a gearbox assembly, comprising a coaxially arranged gear input shaft connected to the rotor shaft to receive a torque from the electric machine; an electric machine control module, configured to control the electric machine, the electric machine control module being installed onto a first wall of the body by stacking over the electric machine and/or gearbox assembly in the direction transverse to the gear input shaft; and an electric connection assembly, configured to electrically connect the electric machine control module to a stator of the electric machine, wherein the electric connection assembly is provided to electrically connect to the stator of the electric machine near a drive end of the rotor shaft of the electric machine.

## Description

### TECHNICAL FIELD

The present disclosure relates to the vehicle field and, more particularly, to an electric drive assembly system, a vehicle including the electric drive assembly system and an assembly method of an electric drive assembly system.

### BACKGROUND

The electric drive assembly system is an integral part of a vehicle and includes an electric machine, a gearbox assembly and an electric machine controller. In a known solution, the electric connection assembly between the electric machine controller and the electric machine is disposed at the non-drive end of the rotor shaft of the electric machine, and the connection between the electric machine and the gearbox assembly is disposed at the drive end of the rotor shaft of the electric machine.

The electric machine length or power is determined by the length between the drive and the non-drive ends of the rotor shaft of the electric machine. Various devices are assembled at both the drive and the non-drive ends of the rotor shaft of the electric machine. For example, the electric connection assembly between the electric machine and the electric machine controller (for example, inverter) is disposed at the non-drive end. For a known electric drive assembly system, any change in the electric machine length will affect the electric connection assembly between the electric machine and the inverter. Therefore, the electric connection assembly needs to be redesigned if the electric machine length is to be changed.

Additionally, the electric connection assembly disposed at the non-drive end of the rotor shaft of the electric machine is cooled by air, so the cooling efficiency is low.

Furthermore, the total length of a known electric drive assembly system is large and there is generally no enough space to install such a long electric drive
assembly system, so it is generally disposed off the centre of the vehicle. This causes an increased length difference between the left and the right drive shafts of the vehicle and even an additional shaft needs to be provided between the left and the right drive shafts to balance the length difference.

Therefore, an electric drive assembly system that can solve the above-mentioned problems is needed in this field.

### SUMMARY

Therefore, the purpose of the present disclosure is to provide an electric drive assembly system, a vehicle including the electric drive assembly system and an assembly method of an electric drive assembly system. In the electric drive assembly system, the electric connection assembly between the electric machine control device and the electric machine is installed at the drive end of the rotor shaft of the electric machine such that the electric machine length can be changed without the need of redesigning the electric connection assembly. Additionally, the electric connection assembly in the electric drive assembly system is cooled by the cooling oil of the gearbox assembly, so the cooling efficiency is high. Furthermore, the electric drive assembly system reduces the length difference between the left and the right drive shafts of the vehicle.

In one aspect, the present disclosure provides an electric drive assembly system. The electric drive assembly system comprises:
a housing, comprising a body and a cover; and
the following, disposed in the housing:
   an electric machine, comprising a rotor shaft;
   a gearbox assembly, comprising a coaxially arranged gear input shaft connected to the rotor shaft to receive a torque from the electric machine;
   an electric machine control module, configured to control the electric machine, the electric machine control module being installed onto a first wall of the body by stacking over the electric machine and/or gearbox assembly in the direction transverse to the gear input shaft; and
   an electric connection assembly, configured to electrically connect the electric machine control module to a stator of the electric machine,
wherein the electric connection assembly is provided to electrically connect to the stator of the electric machine near a drive end of the rotor shaft of the electric machine, and
wherein the first wall is provided with at least one opening that allows the electric connection assembly to pass through.

In one embodiment, the electric connection assembly comprises a plurality of busbars, an injection moulding part and a seal, the injection moulding part is disposed on the busbars and closes the opening, and the seal is disposed between the injection moulding part and the first wall.

In one embodiment, the injection moulding part is formed on the plurality of busbars by injection moulding.

In one embodiment, the busbars pass through the opening and comprise first sections connected to the stator and second sections connected to the electric machine control module.

In one embodiment, the cover comprises a gearbox cover, an electric machine cover, and a control module cover, wherein the first sections are located within a third accommodating space limited by the body of the housing and the electric machine cover, and at least partially extends in the direction transverse to the gear input shaft, and the second sections are located within a second accommodating space limited by the body of the housing and the control module cover.

In one embodiment, the body is provided with other opening in a second wall protruded at the drive end of the rotor shaft, and the other opening expose at least a part of the first sections.

In one embodiment, the electric connection assembly is fixed to the body by using a connector.

In one embodiment, the electric machine control module comprises a plurality of output terminals corresponding to the plurality of busbars, and the arrangement direction of the plurality of output terminals is in parallel with the extension direction of the gear input shaft.

In one embodiment, the electric machine control module comprises a plurality of output terminals corresponding to the plurality of busbars, and the arrangement direction of the plurality of output terminals is perpendicular to the extension direction of the gear input shaft.

In one embodiment, the first sections extend in a direction perpendicular to the gear input shaft, and the second sections extend between the first sections and the output terminals corresponding to the first sections.

In one embodiment, the first sections and/or the second sections are arranged side by side in their respective width directions or at least partially arranged side by side in their respective thickness directions.

In one embodiment, the plurality of busbars pass through the same opening or corresponding plurality of openings in the first wall.

In one more aspect, the present disclosure provides a vehicle. The vehicle comprises the above-mentioned electric drive assembly system.

In another aspect, the present disclosure provides an assembly method of an electric drive assembly system. The assembly method comprises:
installing the electric machine in the housing of the electric drive assembly system;
inserting the electric connection assembly into at least one opening disposed in the first wall of the body in the direction transverse to the rotor shaft from the outside of the body of the housing at the drive end of the rotor shaft of the electric machine;
connecting the electric connection assembly to the stator of the electric machine;
installing the gearbox assembly in the housing and the electric machine control module to the first wall; and
connecting the electric connection assembly to the electric machine control module.

In one embodiment of the method, the electric drive assembly system is configured as described above.

### BRIEF DESCRIPTION OF THE DRAWINGS

To clearly describe the technical solution in the embodiments of the present disclosure, the drawings of the embodiments of the present disclosure will be briefly introduced below. The drawings are only used to show some embodiments of the present disclosure and do not limit all embodiments of the present disclosure here. In the drawings:
Fig. 1 is a schematic of an electric drive assembly system according to one embodiment of the present disclosure.
Fig. 2 is a partial exploded view of the electric drive assembly system according to Fig. 1.
Fig. 3 is a schematic of the electric connection assembly and gearbox assembly disposed inside the housing of the electric drive assembly system according to Fig. 1.
Fig. 4 is a top view of the electric connection assembly according to Fig. 3.
Fig. 5 is a schematic of an electric connection assembly of an electric drive assembly system according to the present disclosure.

### DETAILED DESCRIPTION

The technical solutions of the embodiments of the present invention will be clearly and completely described below by referring to the drawings of the particular embodiments of the present disclosure so that the purposes of the technical solutions, the technical solutions and the advantages of the present invention are clearer. In the drawings, identical reference numerals denote identical parts. It is important to note that the embodiments described are only some of embodiments of the present disclosure and are not all embodiments. All other embodiments obtained by those of ordinary skill in the art based on the described embodiments of the present disclosure without any creative work fall within the scope of protection of the present disclosure.

Unless otherwise defined, technical or scientific terms used herein shall have ordinary meanings as understood by those of ordinary skill in the art to which this disclosure belongs. "First", "second" and similar terms used in the patent application specification and claims of the present disclosure do not indicate any sequence, quantity or importance, and are only used to distinguish different constituent parts. Likewise, terms such as "a" and "one" do not necessarily represent a quantity limit. "Comprise", "include", "have" or any other similar term means that the element or object preceding the term covers the elements or objects and equivalents thereof listed after the term but does not exclude other elements or objects. A term like "connected" or "linked", rather than being limited to the physical or mechanical connection or link shown in a drawing, may include a connection or link equivalent thereto, irrespective of whether it is direct or indirect. "Upper", "lower", "left", "right", etc., are only used to indicate a relative positional relationship, and when the absolute position of the described object has changed, the relative positional relationship may also change accordingly.

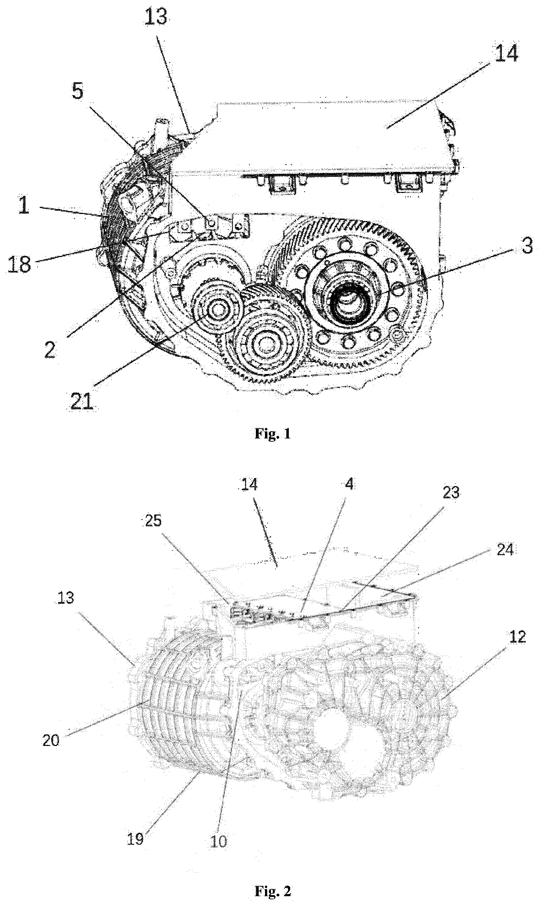

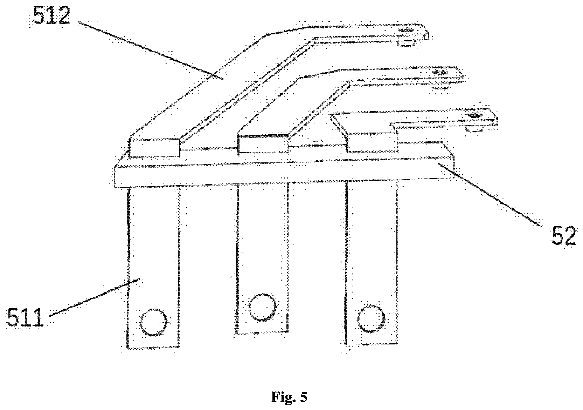

Preferred embodiments of an electric drive assembly system for a vehicle according to the present disclosure will be described in detail below with reference to Figs. 1 through 5. Figs. 1 through 4 show an electric drive assembly system included in a vehicle according to one embodiment of the present disclosure. Fig. 5 shows an electric connection assembly of an electric drive assembly system included in a vehicle according to the present disclosure..

As shown in Figs 1 through 4, the electric drive assembly system of the present disclosure comprises a housing 1, and the housing 1 includes a body 11 and a cover. Additionally, as shown in Figs. 1 through 3, the electric drive assembly system comprises an electric machine 2, a gearbox assembly 3, an electric machine control module 4 and an electric connection assembly 5 disposed inside the housing 1. The electric machine control module 4 may be, for example, an inverter that converts DC into fixed- or variable-frequency voltage AC that is input to the electric machine 2. The electric machine 2 is, for example, a permanent magnet synchronous motor or AC asynchronous motor. There is drive connection between the electric machine 2 and the gearbox assembly 3 so that the torque of the electric machine 2 is output after deceleration by the gearbox assembly 3. The electric machine control module in Fig. 1 is invisible because it is located in the housing. Installing devices such as the electric machine 2, the gearbox assembly 3 and the electric machine control module 4 in a housing can achieve a highly integrated design of the electric drive assembly system, saving space.

Specifically, the electric machine 2 has a rotor shaft (not shown in the figures). The electric machine 2 may include a rotor and a stator 22. The fixed part of the electric machine is called the stator and the rotating part is called the rotor. For example, the stator consists of a core, windings and a base, and the core is generally formed by stacking silicon steel sheets. The rotor is fixed to the base by using a bearing or shaft sleeve and includes a rotor shaft and a rotor core mounted on the rotor shaft. The electric machine control module 4 is connected to the terminals of the stator to input AC to the stator to generate a rotating magnetic field. The rotor is cut by magnetic lines of force in the rotating magnetic field to generate an output current. Additionally, the wheels of the vehicle can reversely drive the rotor to induce a rotating magnetic field in the other direction, and the electric machine control module 4 that is an inverter transfers power back to the battery.

The gearbox assembly 3 has a gear input shaft 21, and the gear input shaft 21 is connected to the rotor shaft and coaxially arranged to receive a torque from the electric machine. For example, the gear input shaft 21 may be rotatably fixed to the rotor shaft of the electric machine. It should be understood that the rotor shaft and the gear input shaft may be two different shafts rotatably connected by a connecting element (for example, a spline), or the same shaft, and are not limited herein.

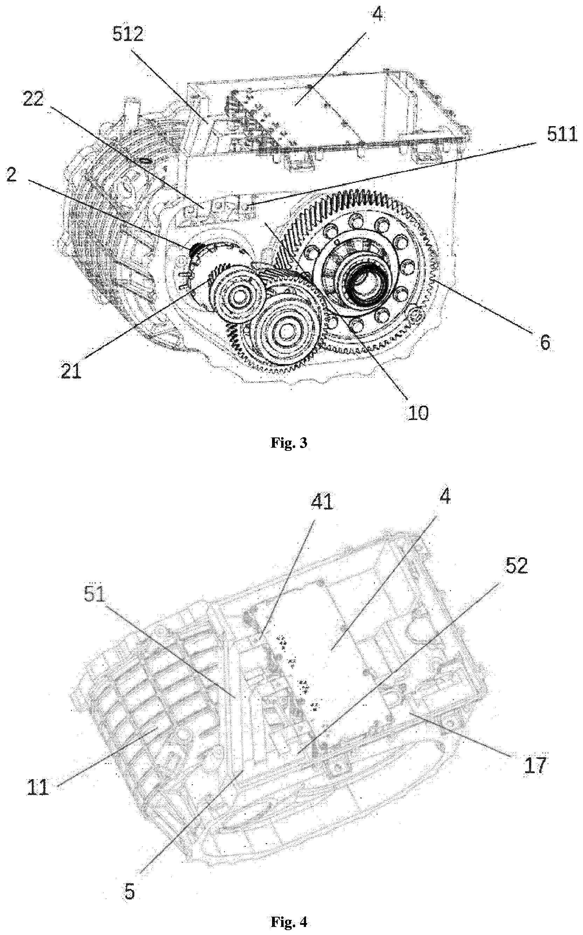

The gearbox assembly 3 may further comprise an intermediate shaft engaged with the gear of the gear input shaft 21 and a differential component (for example, the differential 6 shown in Fig. 3) and can output the torque generated by the electric machine 2 after deceleration. Because the arrangement of the gearbox assembly 3 is a common means in the art, it is not specifically described herein.

The electric machine control module 4 is configured to control the electric machine 2. The electric machine control module 4 may include various electronic and electrical control elements, for example in the form of a circuit board. By using electronic and electrical control elements to control the IGBT integrated power module, the electric machine control module 4 can output a controllable three-phase sinusoidal AC current, controlling the speed and torque of the electric machine. Because the electric machine control module 4 is common in the art, it is not specifically described herein.

Additionally, the electric machine control module 4 is installed onto a first wall 17 of the body 11 by stacking over the electric machine 2 and/or gearbox assembly 3 in the direction transverse to the gear input shaft 21. As shown in Fig. 4, the first wall 17 may be a top wall of the body 11. For example, the electric machine control module 4 in Figs. 1 through 4 is stacked over the gearbox assembly 3 in the vertical direction perpendicular to the gear input shaft 21, which can be briefly described as the electric machine control module 4 being stacked over the gearbox assembly 3. In other embodiments, the electric machine control module 4 is stacked over the electric machine 2 in the vertical direction perpendicular to the gear input shaft 21, which can be briefly described as the electric machine control module 4 being stacked over the electric machine 2. In other words, the electric machine control module 4 in Figs. 1 through 4 is stacked over the electric machine 2 in the direction transverse to the gear input shaft 21 and oblique with respect to the vertical direction in Figs. 1 through 3. The specific arrangement position of the electric machine control module 4 depends on the arrangement form of the electronic components of the electric machine control module 4, the form of the housing 1, or the arrangement of the electric machine 2 or gearbox assembly 3.

As shown in Figs. 1 through 3, the cover comprises a gearbox cover 12, an electric machine cover 13, and a control module cover 14. As shown in Fig. 2, the control module cover 14 may be located at the top of the body 11, and the gearbox cover 12 and the electric machine cover 13 are located at both ends of the body 11, that is the drive and the non-drive ends of the rotor shaft of the electric machine. The gearbox assembly 3 is disposed within a first accommodating space formed by the body 11 and the gearbox cover 12. The electric machine control module 4 is disposed within a second accommodating space formed by the body 11 and the control module cover 14. The electric machine 2 is disposed within a third accommodating space formed by the body 11 and the electric machine cover 13. Specifically, the body 11 of the housing includes a base 19 and a plurality of walls extending away from the base toward its top edge 23, such as a second wall 10, a third wall 20, a fourth wall 24, and a fifth wall 25, which may also be called side walls. The second wall 10, the fourth wall 24 and the fifth wall 25 are, for example, walls extending in the direction perpendicular to the base 19, and the third wall 20 is, for example, a wall extending in the direction partially perpendicular to the base 19. The second wall 10 is located near the drive end of the rotor shaft of the electric machine, and the fifth wall 25 is located near the non-drive end of the rotor shaft of the electric machine. The third wall 20 and the fourth wall 24 extend between the second wall 10 and the fifth wall 25. Additionally, the body 11 further comprises a first wall 17 as a top wall, as described above. The second wall 10 may be bent near the top edge 23 to define the first accommodating space together with the gearbox cover 12. The first wall 17 may be recessed with respect to the top edge 23 to define a second accommodating space together with the control module cover 14. The third wall 20, for example, partially has a cylindrical form to define a third accommodating space together with the first wall 17, the second wall 10, and the electric machine cover 13.

The electric connection assembly 5 is configured to electrically connect the electric machine control module 4 to the stator 22 of the electric machine 2, or rather, terminals of the stator 22. The electric connection assembly 5 is provided to electrically connect to the stator 22 of the electric machine 2 near the gear input shaft 21. The position of the stator 22 is shown in Fig. 3. In other words, the electric connection assembly 5 is provided to electrically connect to the stator 22 near the drive end of the rotor shaft of the electric machine. As shown in Fig. 4, an opening that allow the electric connection assembly 5 to pass through are disposed in the first wall 17 of the body 11 of the housing 1 (not shown in the figure). For example, the opening is located near the drive end of the rotor shaft of the electric machine and in the unoccupied space above the gear input shaft 21. In other embodiments, the opening is located in the unoccupied space above the differential 6. Therefore, the electric drive assembly system of the present disclosure can utilize the space not occupied by the gearbox assembly or differential at the drive end of the rotor shaft of the electric machine better to achieve the more integrated design.

Arranging the electrical connection component 5 near the drive end of the rotor shaft of the electric machine of the electric drive assembly system allows its non-drive end to be extensible. In other words, the body 11 of the housing 1 is extensible in the direction towards the electric machine cover 13, that is, the length of the electric machine or stator housed therein is changeable and the electric machine control module and the electrical connection component do not need to be redesigned. This allows the electric drive assembly system of the present disclosure to have a flexible application and a low cost.

As shown in Figs. 3 through 5, the electric connection assembly 5 comprises a plurality of busbars 51 (for example, copper busbars) and an injection moulding part 52. The number of the busbars 51 may be three, and they are respectively used for the three-phase current. The injection moulding part 52 is disposed on the busbars 51 and closes the above-mentioned opening, as shown in Fig. 4. For example, the injection moulding part 52 is formed on the plurality of busbars 51 by injection moulding. Additionally, the electric connection assembly 5 may further comprise a seal (not shown in the figures) to seal the second accommodating space containing the electric machine control module 4 with respect to the first accommodating space containing the gearbox assembly 3, and the seal is provided between the injection moulding part 52 and the first wall 17 of the housing 1. For example, the seal may be installed in the groove around the opening. In other embodiments, the seal may be installed in the groove on one side of the injection moulding part 52 facing the opening. For example, the seal may be integrated with the busbars 51 and the injection moulding part 52, or may be a separate component. Additionally, as shown in Fig. 4, the injection moulding part 52 is installed to the opening from the outside of the body 11, or rather, from the top side of the body 11. For example, the electric connection assembly 5 is fixed to the body 11 by using a connector. For example, the electric connection assembly 5 is fixed to the first wall 17 with screws or bolts passing through the mounting holes in the injection moulding part 52. Of course, other methods such as bonding, riveting and welding can also be used in the present disclosure.

The electric machine control module 4 comprises a plurality of output terminals 41 corresponding to the plurality of busbars 51, as shown in Fig. 4. In some embodiments such as embodiments in Figs. 1 through 4, the arrangement direction of the plurality of output terminals 41 is in parallel with the extension direction of the gear input shaft 21. In other embodiments, the arrangement direction of the plurality of output terminals 41 is perpendicular to the extension direction of the gear input shaft 21.

Specifically, the busbars 51 pass through the opening and comprise first sections 511 connected to the stator 22 and second sections 512 connected to the electric machine control module 4, as shown in Figs. 3 and 4. The first sections 511 are located within a third accommodating space limited by the body 11 of the housing 1 and the electric machine cover 13 (that is, the space containing the electric machine 2), and at least partially extend in the direction transverse to the gear input shaft 21. The phrase, "transverse to", as used herein includes being perpendicular to the gear input shaft 21, or being inclined at an angle with the gear input shaft 21. The second sections 512 are located within a second accommodating space limited by the body 11 of the housing 1 and the control module cover 14. As shown in Figs. 3 and 4, the first sections 511 extend in a direction perpendicular to the gear input shaft 21, the second sections 512 extend between the first sections 511 and the output terminals 41 corresponding to the first sections 511 and may be bent, as shown in Fig. 5. In some embodiments, the first sections 511 are arranged side by side in their width direction; as shown in Fig. 5, there may be a large interval between the three first sections 511. In other embodiments, the first sections 511 are at least partially arranged side by side in their thickness directions. Of course, the plurality of first sections 511 may be completely arranged side by side in the thickness direction such that only one first section 511 can be seen when viewed in the thickness direction of the first sections 511. The arrangement mode of the second sections 512 may be similar to the arrangement mode of the first sections 511. For example, the second sections 512 are arranged side by side in their width direction. For example, the second sections 512 are at least partially arranged side by side in their thickness direction, so they are overlapped such that only one second section 512 can be seen when viewed in the thickness direction of the second sections 512. Compared with the electric connection assembly in Fig. 5, the electric connection assembly whose first sections 511 and second sections 512 are arranged side by side in the thickness direction uses a small injection moulding part and the required sealing area is reduced, achieving a better sealing effect, more effective utilization of space, and a higher level of integration. Additionally, in some embodiments, the plurality of busbars 51 pass through the same opening in the first wall 17. In some embodiments, the plurality of busbars 51 pass through the plurality of openings in the first wall 17 and the number of openings corresponds to the number of busbars. The above-mentioned different busbar designs depend on the arrangement of the housing, the gearbox assembly and the electric machine. In other words, the busbar design depends on the remaining space not occupied by the gearbox assembly and the electric machine at the drive end. In this way, the electric drive assembly system of the present disclosure can utilize the space at the gearbox assembly better to achieve a more integrated design.

Additionally, as shown in Figs. 1 and 2, the body 11 is provided with other opening 18 in a second wall 10 protruded at the drive end of the rotor shaft, and the other opening 18 expose at least a part of the first sections 511. In this way, the cooling oil stored in the gearbox assembly 3 may splash onto and cool the exposed part of the first sections 511.

Therefore, the electric drive assembly system of the present disclosure has a higher cooling efficiency.

The left and the right drive shafts of the vehicle are connected to the differential of the gearbox assembly. For example, the electric drive assembly system is not on the centre of the vehicle. In a vehicle of the present disclosure, the electric connection assembly between the electric machine control module and the electric machine in the above-mentioned electric drive assembly system is installed at the drive end of the rotor shaft of the electric machine to reduce the total length of the electric machine such that the electric drive assembly system is disposed closer to the centre of the vehicle, decreasing the length difference between the left and the right drive shafts. This also reduces the probability of or avoids using an additional shaft to balance the length difference between the left and the right drive shafts.

An assembly method of an electric drive assembly system according to the present disclosure comprises: installing the electric machine 2 in the housing 1 of the electric drive assembly system; inserting the electric connection assembly 5 into at least one opening disposed in the first wall 17 of the body 11 in the direction transverse to the rotor shaft (i.e. the direction transverse to the gear input shaft 21) from the outside of the body 11 of the housing 1 at the drive end of the rotor shaft of the electric machine 2; connecting the electric connection assembly 5 to the stator 22 of the electric machine 2 (or rather, terminals of the stator 22); installing the gearbox assembly 3 in the housing 1 and the electric machine control module 4 to the first wall 17; and connecting the electric connection assembly 5 to the electric machine control module 4. The above-mentioned electric drive assembly system may be assembled using the assembly method. For example, the step for inserting the above-mentioned electric connection assembly 5 can be performed in a direction perpendicular to the gear input shaft 21, that is, the vertically downward direction in Fig. 3.

The technical features disclosed above are not limited to the combinations of the disclosed features with other features, and according to the purpose of the present invention, those skilled in the art may make other combinations of the technical features, which shall be judged by the purpose of the present disclosure.

## Claims

1. An electric drive assembly system, **characterized in that** the electric drive assembly system comprises:
a housing (1), comprising a body (11) and a cover; and
the following, disposed in the housing (1):
an electric machine (2), comprising a rotor shaft;
a gearbox assembly (3), comprising a coaxially arranged gear input shaft (21) connected to the rotor shaft to receive a torque from the electric machine;
an electric machine control module (4), configured to control the electric machine (2), the electric machine control module (4) being installed onto a first wall (17) of the body by stacking over the electric machine (2) and/or gearbox assembly (3) in the direction transverse to the gear input shaft (21); and
an electric connection assembly (5), configured to electrically connect the electric machine control module (4) to a stator (22) of the electric machine (2),
wherein the electric connection assembly (5) is provided to electrically connect to the stator (22) of the electric machine (2) near a drive end of the rotor shaft of the electric machine, and
wherein the first wall (17) is provided with at least one opening that allows the electric connection assembly (5) to pass through.

2. The electric drive assembly system according to Claim 1, **characterised in that** the electric connection assembly (5) comprises a plurality of busbars (51), an injection moulding part (52) and a seal, the injection moulding part (52) being disposed on the busbars (51) and closing the opening, the seal being disposed between the injection moulding part and the first wall (17).

3. The electric drive assembly system according to Claim 2, **characterised in that** the injection moulding part (52) is formed on the plurality of busbars (51) by injection moulding.

4. The electric drive assembly system according to Claim 2, **characterised in that** the busbars (51) pass through the opening and comprise first sections (511) connected to the stator (22) and second sections (512) connected to the electric machine control module (4).

5. The electric drive assembly system according to Claim 4, **characterised in that** the cover comprises a gearbox cover (12), an electric machine cover (13), and a control module cover (14),
wherein the first sections (511) are located within a third accommodating space limited by the body (11) of the housing (1) and the electric machine cover (13), and at least partially extend in a direction transverse to the gear input shaft (21), and the second sections (512) are located within a second accommodating space limited by the body (11) of the housing (1) and the control module cover (14).

6. The electric drive assembly system according to Claim 5, **characterised in that** the body (11) is provided with other opening (18) in a second wall (10) protruded at the drive end of the rotor shaft, the other opening exposing at least a part of the first sections (511).

7. The electric drive assembly system according to Claim 2, **characterised in that** the electric connection assembly (5) is fixed to the body (11) by using a connector.

8. The electric drive assembly system according to Claim 4, **characterised in that** the electric machine control module (4) comprises a plurality of output terminals (41) corresponding to the plurality of busbars (51), the arrangement direction of the plurality of output terminals (41) being in parallel with the extension direction of the gear input shaft (21).

9. The electric drive assembly system according to Claim 4, **characterised in that** the electric machine control module (4) comprises a plurality of output terminals (41) corresponding to the plurality of busbars (51), the arrangement direction of the plurality of output terminals (41) being perpendicular to the extension direction of the gear input shaft (21).

10. The electric drive assembly system according to Claim 8 or 9, **characterised in that** the first sections (511) extend in a direction perpendicular to the gear input shaft (21), and the second sections (512) extend between the first sections (511) and the output terminals (41) corresponding to the first sections (511).

11. The electric drive assembly system according to Claim 8 or 9, **characterised in that** the first sections (511) and/or the second sections (512) are arranged side by side in their respective width directions or at least partially arranged side by side in their respective thickness directions.

12. The electric drive assembly system according to Claim 11, **characterised in that** the plurality of busbars (51) pass through the same opening or corresponding openings in the first wall (17).

13. A vehicle, **characterised in that** the vehicle comprises the electric drive assembly system according to any of Claims 1 to 12.

14. An assembly method of an electric drive assembly system, **characterised in that** the assembly method comprises:
installing the electric machine (2) in the housing (1) of the electric drive assembly system;
inserting the electric connection assembly (5) into at least one opening disposed in the first wall (17) of the body (11) in the direction transverse to the rotor shaft from the outside of the body (11) of the housing (1) at the drive end of the rotor shaft of the electric machine (2);
connecting the electric connection assembly (5) to the stator (22) of the electric machine (2);
installing the gearbox assembly (3) in the housing (1) and the electric machine control module (4) to the first wall (17); and
connecting the electric connection assembly (5) to the electric machine control module (4).

15. The assembly method according to Claim 14, **characterised in that** the electric drive assembly system is configured according to any of Claims 1 to 12.
